# EUROPEAN PATENT APPLICATION

(11) **EP 4 608 079 A1**
(43) Date of publication of application: **27.08.2025**
(21) Application number: 22962719.5
(22) Date of filing: 19.10.2022
(51) Int. Cl.: H05K 5/03, A24F 40/40, A24F 40/60, H05K 5/02

(54) **ELECTRONIC APPARATUS AND PROGRAM**

(71) Applicant: Japan Tobacco Inc., Tokyo 105-6927 (JP)
(72) Inventor: FUJIKI, Takashi, Tokyo 130-8603 (JP); YOSHIDA, Ryo, Tokyo 130-8603 (JP)
(74) Representative: Hoffmann Eitle
(86) International application number: PCT/JP2022/038861
(87) International publication number: WO 2024/084607

(57) **Abstract**

An electronic apparatus having a control unit and a battery, wherein the control unit identifies a functional type of a cover member to be attached or attached to an apparatus main body.

## Description

### [Technical Field]

The present disclosure relates to an electronic apparatus and a program.

### [Background Art]

Some portable electronic apparatuses may be provided with a replaceable cover member from a design point of view or from a functional point of view. The cover member may constitute a part of the main body, like the main body cover, or may be optional to attach, like the protective cover.

### [Citation List]

### [Patent Literature]

[PTL 1] WO 2019-084161

### [Summary of Invention]

### [Technical Problem]

Currently, the cover member is often provided from a design point of view. In the future, there is also a possibility that sensors, memory, etc. will be attached to the cover member. When a cover member equipped with a sensor or memory, etc. appears, new value may be realized through the cooperation between the electronic apparatus and the cover member. However, if the electronic apparatus cannot recognize the functional type of the attached cover member, it may not be possible to cooperate sufficiently with the cover member.

In view of the above issues, the present disclosure provides techniques to facilitate cooperation with a cover member attached in an electronic apparatus.

### [Solution to Problem]

One embodiment of the present disclosure provides an electronic apparatus having a control unit and a battery, wherein the control unit identifies a functional type of a cover member to be attached or attached to an apparatus main body.

The control unit may specify an electronic component provided to the cover member on the basis of an identification result of the functional type.

The control unit may control cooperation with an electronic component provided to the cover member on the basis of an identification result of the functional type.

The control unit may identify the functional type of the cover member through detection of a structural feature provided to the cover member.

The control unit may identify the functional type of the cover member through reading a magnetic pattern.

The control unit may identify the functional type of the cover member by information read through communication with the cover member.

The control unit may identify the functional type of the cover member using an image of the cover member imaged by a camera.

The control unit here may read character information on the cover member as the image.

The control unit here may read graphic code affixed on the cover member as the image.

If the electronic apparatus further includes a heating unit to heat the aerosol source, the control unit may identify the functional type on the basis of information representing a control sequence readable from the cover member.

The attachment of the cover member on the apparatus main body may cause a portion of a face of the apparatus main body to be covered with the cover member.

If the electronic apparatus further includes a heating unit for heating the aerosol source, the control unit may detect the attachment of the cover member on the apparatus main body as one of conditions to enable heating of the aerosol source by the heating unit.

The cover member attached to the apparatus main body may allow operation of a switch provided on the apparatus main body by pressing by a user.

A portion of the apparatus main body that is not covered by the cover member may form an integral external appearance with the cover member.

One embodiment of the present disclosure provides a program for causing a computer provided in an electronic apparatus having a battery to realize a function for identifying a functional type of a cover member to be attached or attached to an apparatus main body.

### [Advantageous Effects of Invention]

According to one embodiment of the present disclosure, it is possible to provide a feature for facilitating cooperation with a cover member attached in an electronic apparatus.

### [Brief Description of Drawings]

[Fig. 1] fig. 1 is a diagram in which a front face side of an aerosol generating device is viewed from diagonally above.
[Fig. 2] fig. 2 is a diagram in which the front face side of the aerosol generating device is viewed from diagonally below.
[Fig. 3] fig. 3 is a diagram in which the aerosol generating device from which a shutter has been removed is viewed from above.
[Fig. 4] fig. 4 is a diagram in which a main body device with a front panel removed is viewed from a front face.
[Fig. 5] fig. 5 is a view of a rear face of the front panel removed from the main body device.
[Fig. 6] fig. 6 is a view of the rear face of another front panel removed from the main body device.
[Fig. 7] fig. 7 is a view schematically showing an internal configuration of the aerosol generating device.
[Fig. 8] fig. 8 is a flowchart illustrating an example of a front panel attachment operation implemented by a control unit on the main body device.
[Fig. 9] fig. 9 is a flowchart illustrating an example of a process for identifying a functional type of the front panel, implemented by the control unit of the main body device of embodiment 1.
[Fig. 10] fig. 10 is a diagram illustrating the attachment of a basic panel on the main body device and non-detection of a structure.
[Fig. 11] fig. 11 is a diagram illustrating the attachment of the front panel, to which a primary battery can be attached, to the main body device, and detection of the structure.
[Fig. 12] fig. 12 is a table illustrating the relationship between the functional types and the presence or absence of the structure in embodiment 1.
[Fig. 13] fig. 13 is a diagram illustrating an example of detecting a difference in the push amount of a detection pin on a sensor side from contact with the structure.
[Fig. 14] fig. 14 is a diagram illustrating an example of communication between a front panel and a main body device in embodiment 2.
[Fig. 15] fig. 15 is a diagram illustrating examples of correspondence between functional types and electronic components attached to the front panel.
[Fig. 16] fig. 16 is a diagram schematically showing a connection relationship of a power system circuit in the main body device with the front panel.
[Fig. 17] fig. 17 is a flowchart illustrating an example of a USB charging operation implemented by a control unit.
[Fig. 18] fig. 18 is a diagram illustrating the USB charging operation.
[Fig. 19] fig. 19 is a diagram illustrating a method for reading a functional type of a front panel in embodiment 3.
[Fig. 20] fig. 20 is a diagram illustrating a method for specifying a functional type of a front panel in embodiment 4.
[Fig. 21] fig. 21 is a diagram illustrating a method for specifying a functional type of a front panel in embodiment 5.
[Fig. 22] fig. 22 is a diagram illustrating a method for specifying a functional type of a front panel in embodiment 6.
[Fig. 23] fig. 23 is a diagram illustrating a method for specifying a functional type of a front panel in embodiment 7.

### [Description of Embodiments]

Embodiments relating to the present disclosure will be described below with reference to the drawings. In the drawings, identical parts are indicated by identical reference signs.

### <Terms>

An aerosol generating device according to the embodiments is a form of electronic cigarette.

In the following description, a substance generated by the aerosol generating device will be referred to as an aerosol. An aerosol refers to a mixture of minute liquid or solid particles suspended in a gas, and air or another gas.

The embodiments describe aerosol generating devices which generate the aerosol without associated burning.

In the following description, the action of a user inhaling the aerosol generated by the aerosol generating device will be referred to as "inhalation" or "a puff".

In each embodiment, an aerosol generating device to which it is possible to attach a solid aerosol source is described. It should be noted that a container storing the solid aerosol source is also referred to as a "capsule" or a "stick-type substrate" depending on the product format. Capsules and stick-type substrates are consumables. Capsules and stick-type substrates therefore have fixed criteria for replacement.

### <Embodiment 1>

### <Example of External Appearance>

An example of the external appearance of an aerosol generating device 1 used in embodiment 1 will be described first of all.

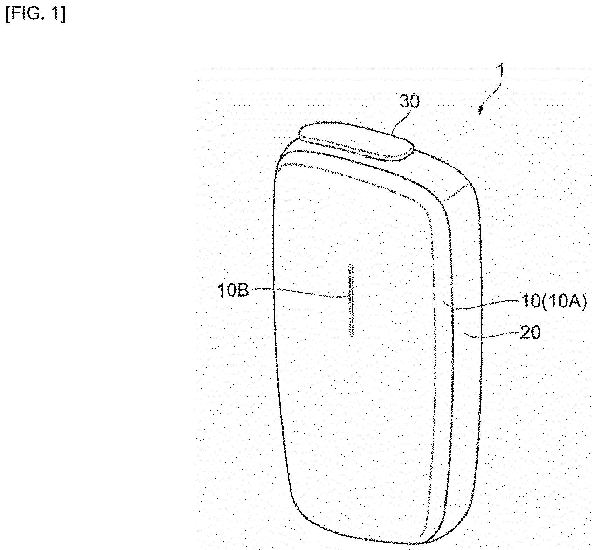

Fig. 1 is a diagram in which a front face side of the aerosol generating device 1 is viewed from diagonally above.

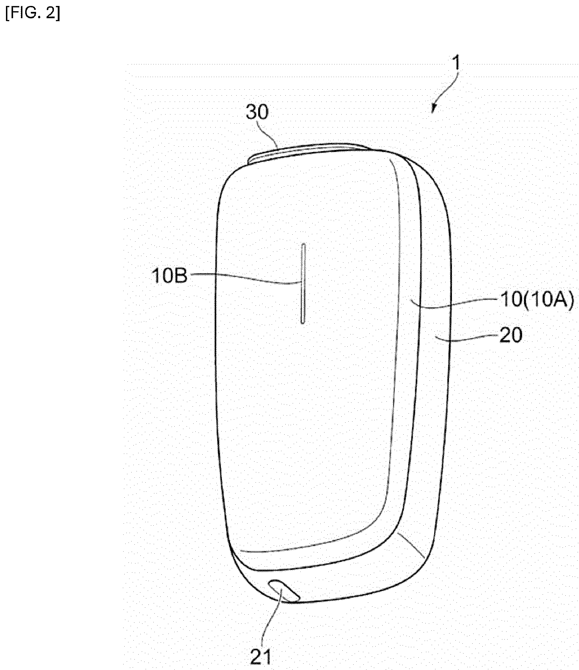

Fig. 2 is a diagram in which the front face side of the aerosol generating device 1 is viewed from diagonally below.

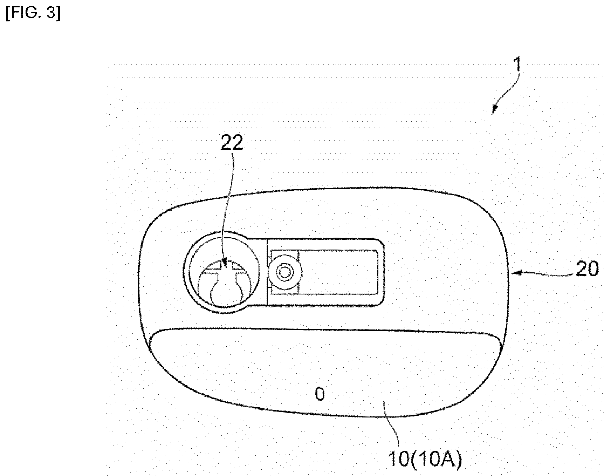

Fig. 3 is a diagram in which the aerosol generating device 1 from which a shutter 30 has been removed is viewed from above.

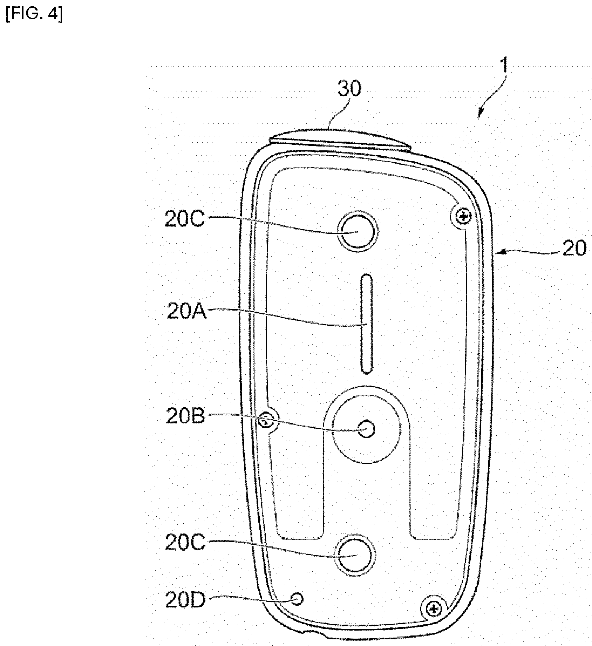

Fig. 4 is a diagram in which a main body device 20 with a front panel 10 removed is viewed from a front face.

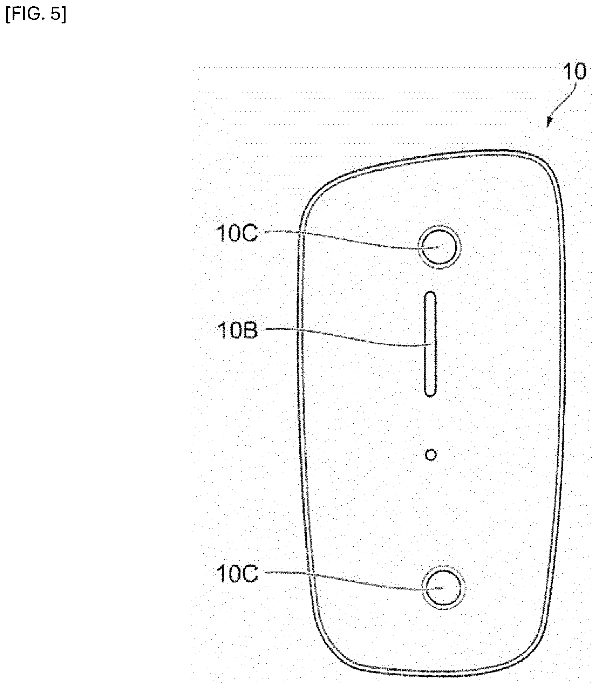

Fig. 5 is a view of a rear face of the front panel 10 removed from the main body device 20.

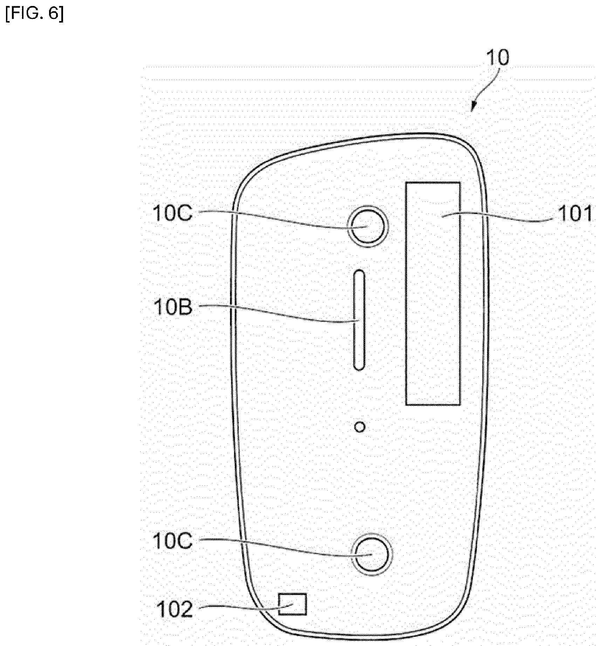

Fig. 6 is a view of a rear face of another front panel 10 removed from the main body device 20.

The aerosol generating device 1 used in this embodiment has a size such that a user can hold it in one hand.

The aerosol generating device 1 comprises: a main body device 20; a front panel 10 to be attached to a front face of the main body device 20; and a shutter 30 which is disposed on an upper face of the main body device 20 and can be slidably operated along the upper face. The main body device 20 here is an example of an apparatus main body.

The front panel 10 is a member which is detachable from the main body device 20. The front panel 10 here is an example of a cover member. It should be noted that the front panel 10 is attached/detached by a user.

The front panel 10 attached to the main body device 20 covers a front face part of the main body device 20, as shown in fig. 1 and 2. In other words, parts of the main body device 20 other than the front face part can also be seen from the outside after the front panel 10 has been attached. Side faces, a back face, an upper face, and a bottom face of the main body device 20 can also be seen from the outside after the front panel 10 has been attached, for example.

The front panel 10 attached to the main body device 20 joins continuously and steplessly with the side faces, upper face, and bottom face of the main body device 20, as shown in fig. 1 and 2, forming an integral external appearance.

One role of the front panel 10 is thus decorative. Moreover, the side faces, upper face and bottom face of the main body device 20 are examples of parts which are not covered by the front panel 10.

The front panel 10 is provided with a window 10B. The window 10B is provided at a position facing a light-emitting element on the main body device 20 side. An LED (= light-emitting diode) 20A (see fig. 4) is used as the light-emitting element in embodiment 1.

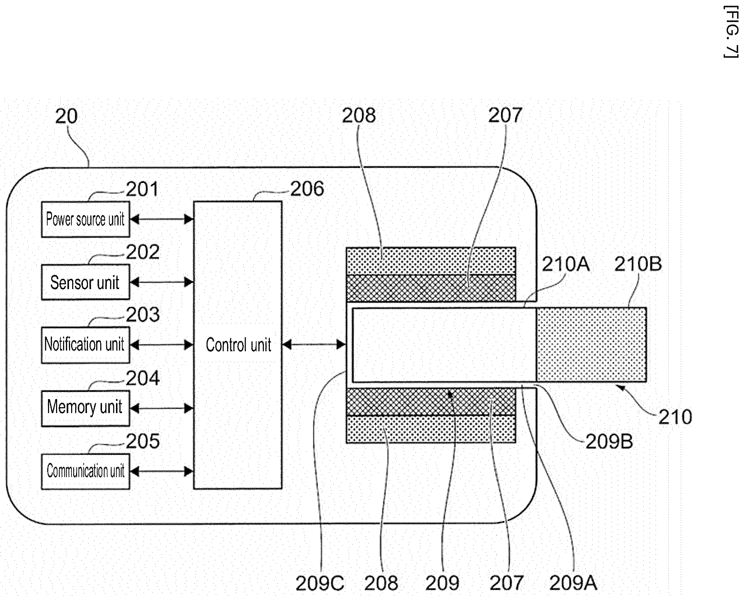

The window 10B in embodiment 1 is composed of a material that transmits light. The window 10B may equally be a slit penetrating from a front surface to a rear surface. Moreover, illumination and flashing of the light-emitting element represent states of operation, etc. of the aerosol generating device 1. The states of operation also include errors. Illumination and flashing of the light-emitting element are controlled by a control unit 206 (see fig. 7) which will be described later.

In addition to its decorative role, the front panel 10 also has the role of alleviating propagation of heat released from the main body device 20, etc. In this embodiment, aerosol generation is therefore permitted only when the front panel 10 is attached to the main body device 20. In other words, the front panel 10 attached to the main body device 20 forms an integral external appearance with the main body device 20 in a state in which an aerosol can be generated.

Furthermore, the front panel 10 serves to protect the main body device 20 from dirt, scratches, etc.

The front panel 10 used in the present embodiment is deformed by a user pushing a position below the window 10B with their fingertips, and the original shape is restored when the user stops pushing.

The front panel 10 of this embodiment is an example of a cover member. Moreover, a main body panel 10A forming the external appearance of the front panel 10 shown in fig. 1 and 2 is an example of a main body portion.

In the present embodiment, two types of front panel 10 are provided: the front panel 10 shown in fig. 5 and the front panel 10 shown in fig. 6. Both front panels 10 can be attached to cover the front portion of the main body device 20.

The difference is that, on the reverse face of the front panel 10 shown in fig. 6 (the face attached to the main body device 20), a primary battery 101 is attached and a structure 102 is present.

The structure 102 is a protuberance, projection, protrusion, blade or other structure relative to the rear face of the front panel 10. The structure 102 may be integrally formed with the front panel 10 or may be attached as a retrofit. The structure 102 here is an example of a structural feature, showing that the structure is the front panel 10 on which the primary battery 101 can be attached.

Note that the primary battery 101 is an example of an electronic component provided on the front panel 10.

The primary battery 101 attached to the front panel 10 is used as an auxiliary power source to compensate for lack of power in the main body device 20. As previously described, the primary battery 101 is attachable/detachable with respect to the rear face of the front panel 10. In other words, if the primary battery 101 has no residual capacity or reduced residual capacity, it can be replaced with a new primary battery 101.

On the other hand, on the rear face of the front panel 10 shown in fig. 5, the primary battery 101 is not attached and there is also no structure 102. Hereinafter, the front panel 10 shown in fig. 5 is also referred to as a basic panel. It should be noted that even for the basic panel, the color, design, etc. may be different.

In the case of the present embodiment, the primary battery 101 is for example a film-type, coin-type, or chip-type battery. The primary battery 101 needs to be thin in all cases so as not to impede attachment of the front panel 10 to the main body device 20. Moreover, the front panel 10 to which the primary battery 101 is fitted is also provided with electrodes and connectors (not depicted) which are used to supply power to the main body device 20. The electrodes for power supply are for contact power supply to the main body device 20, and in the case of contactless power supply (i.e., wireless power), a coil (not shown) is added as an electronic component.

Standards for the contactless power supply referred to here include standards based on electromagnetic induction systems, such as the Qi standard and the NFC (= near field communication) standard, and electric field induction systems.

A type C USB (= universal serial bus) connector 21 is provided on the bottom face side of the main body device 20. The shape and type of USB connector 21 are given by way of example. In other words, the USB connector 21 may be a USB other than type C. In embodiment 1, the USB connector 21 is used for charging a power source unit 201 (see fig. 7) built into the main body device 20, for example.

A hole 22 for insertion of a stick-type substrate 210 (see fig. 7) accommodating an aerosol source is provided in an upper face portion of the main body device 20.

The stick-type substrate 210 used in the present embodiment stores a solid aerosol source in a paper tube molded substantially into a cylindrical shape. The hole 22 is exposed by sliding the shutter 30 to an open position, and hidden by sliding the shutter 30 to a closed position.

The hole 22 has a cylindrical shape virtually the same as that of the stick-type substrate 210 in the case of embodiment 1. The diameter of an opening part of the hole 22 constitutes the dimension of a stick-type substrate 210 which can be inserted. In other words, the diameter of the stick-type substrate 210 is the dimension which can be inserted into the hole 22.

A magnet, for example, is attached to a rear face of the shutter 30. Meanwhile, a Hall IC is attached to the main body device 20 in a movable range of the shutter 30.

The Hall IC is a magnetic sensor formed by a Hall element and an operational amplifier, etc., and outputs a voltage commensurate with the intensity of the magnetic field passing across the Hall element.

In this embodiment, opening and closing of the shutter 30 is detected from a change in the voltage output from the Hall IC accompanying sliding of the shutter 30. That is to say, it is detected whether the shutter 30 is at the closed position or the open position.

A button 20B is disposed substantially in the center of the front face of the main body device 20. As indicated above, the button 20B is operable while the front panel 10 is in an attached state.

The button 20B is used, for example, for turning the power source of the main body device on and off, for turning the power supply to a heating unit 207 (see fig. 7) for heating the aerosol source on and off, and for Bluetooth (registered trademark) pairing commands, etc.

Moreover, a reset function is performed by a long press (e.g., pressing for 5 seconds or more) of the button 20B while the front panel 10 is removed from the main body device 20.

BLE (= Bluetooth low energy) is used as Bluetooth in this embodiment.

Magnets 20C used for attaching the front panel 10 are disposed on the upper portion and lower portion of the front face of the main body device 20. The magnets 20C are provided at positions facing magnets 10C provided on the inner side of the front panel 10. The magnets 10C on the front panel 10 are N poles, and the magnets 20C on the main body device 20 side are S poles, for example. The front panel 10 is detachably attached to the main body device 20 by the force of attraction of the magnets.

It should be noted that either the magnets 10C or the magnets 20C may be metal pieces made of iron or another magnetic metal. Incidentally, attachment of the front panel 10 to the main body device 20 is detected by means of the Hall IC provided on the main body device 20 side.

Various other types of electronic components required for generating an aerosol are built into the main body device 20. In this sense, the main body device 20 is an example of an electronic device specifically for generating an aerosol. Moreover, in a narrow sense the main body device 20 is referred to as an aerosol generating device.

### <Internal Configuration>

Fig. 7 is a view schematically showing an internal configuration of the aerosol generating device 1.

It should be noted that fig. 7 shows a state in which the stick-type substrate 210 is fitted to the main body device 20. Furthermore, the internal configuration shown in fig. 7 is intended to illustrate the electronic components provided in the main body device 20 and positional relationships thereof. For this reason, the external appearance of the electronic components, etc. shown in fig. 7 does not always match the external appearance diagrams described above.

The main body device 20 comprises: a power source unit 201, a sensor unit 202, a notification unit 203, a memory unit 204, a communication unit 205, a control unit 206, a heating unit 207, a heat insulating portion 208, and a holding portion 209.

The stick-type substrate 210 in fig. 7 is held in the holding portion 209, and the user inhales the aerosol in this state.

The power source unit 201 of this embodiment is a unit for supplying power to the main body device 20. The power source unit 201 stores power using for example a lithium-ion secondary battery or a capacitor.

The power source unit 201 is chargeable from an external power source. A mains power source or a mobile battery, for example, is feasible as an external power source in this embodiment.

The sensor unit 202 is an electronic component for detecting various types of information relating to the main body device 20.

The sensor unit 202 has a pressure sensor such as a microphone capacitor, or a flow rate sensor, for example. The sensor unit 202 serving as a sensor outputs detected information to the control unit 206. For example, when a change in air pressure or a flow of air accompanying inhalation has been detected, the sensor unit 202 outputs a numerical value representing inhalation by the user to the control unit 206.

The sensor unit 202 has an input device for receiving user input, for example. The input device is a button or a switch, for example. In this embodiment, the button 20B (see fig. 4) is used as the input device.

The button 20B is used for switching a main power source on and off, and for switching starting and stopping of electrical supply to the heating unit 207 (i.e., starting and stopping of aerosol generation), etc.

The content of user commands is output from the sensor unit 202 to the control unit 206. It should be noted that the button 20B is not only an example of a button but also an example of a switch.

The sensor unit 202 additionally has a temperature sensor for detecting the temperature of the heating unit 207. The temperature sensor detects the temperature of the heating unit 207 on the basis of an electrical resistance value of a conductive track of the heating unit 207, for example. The detected electrical resistance value is output from the sensor unit 202 to the control unit 206. It should be noted that the control unit 206 calculates the temperature of the heating unit 207 on the basis of the electrical resistance value. In other words, the control unit 206 calculates the temperature of the stick-type substrate 210 which is held in the holding portion 209.

Additionally, the sensor unit 202 has a sensor 20D (see fig. 4) which is used to detect the functional type of the front panel 10 attached to the front face of the main body device 20. In the case of the present embodiment, the functional type subjected to detection is whether or not power of the primary battery 101 can be used. Note that the sensor 20D sets the presence or absence of the structure 102 as the subject of detection. For example, when the presence of the structure 102 is detected, it is possible to receive a supply of power from the attached front panel 10. On the other hand, when the structure 102 is not detected, a supply of power cannot be received from the attached front panel 10.

In the case of the present embodiment, a contact detection sensor, a displacement sensor, or a push amount detection sensor, for example, is used for the sensor 20D.

The contact detection sensor detects the presence or absence of contact with the structure 102 through a change in pressure or a change in impedance, for example.

The displacement sensor detects the distance to the opposing face (the rear face of the front panel 10 or the face of the structure 102).

The push amount detection sensor detects the presence or absence of contact with the structure 102 through the measurement of the push amount of a movable pin with spring attached.

The sensor unit 202 additionally has a capacitive sensor, an optical sensor or a pressure sensor, etc. for detecting insertion of the stick-type substrate 210 into the holding portion 209, and proximity of objects, etc. through a change in electrostatic capacitance.

The sensor unit 202 furthermore has an optical color sensor for distinguishing individual stick-type substrates 210 by color, a radio-frequency identification (= RFID) reader, or an NFC (near field communication) reader, etc.

The sensor unit 202 furthermore has a biosensor for measuring the user's heart rate, etc., and a fingerprint sensor used for unlocking, etc.

The sensor unit 202 furthermore has an acceleration sensor or a gyro sensor, etc. for detecting movement of the user.

The notification unit 203 is an electronic component for notifying the user of various types of information relating to the main body device 20. The notification unit 203 comprises the LED 20A (see fig. 4) or another light-emitting device. For example, when the power source unit 201 needs to be charged, when the power source unit 201 is in the process of being charged, or when there is an abnormality in the main body device 20, the LED 20A emits light with different patterns for each.

The patterns as referred to here include different colors and different timings for illumination/extinguishing, etc.

Instead of or as well as the abovementioned light-emitting device, the notification unit 203 may also be configured by a display device for displaying images, a sound output device for outputting sounds, or a vibration device for causing the main body device 20 to vibrate, etc. The light-emitting device, display device, sound output device and vibration device, etc. are also examples of notification units for notifying information.

The notification unit 203 may additionally notify the user of a state in which the aerosol can be inhaled. This notification is made when the temperature of the stick-type substrate 210 heated by means of the heating unit 207 has reached a predetermined temperature.

The memory unit 204 stores various types of information relating to operation of the main body device 20. The memory unit 204 is configured by a non-volatile storage medium such as a flash memory, for example.

Information stored in the memory unit 204 includes an operating system (= OS) and firmware (= FW), and other programs, for example. The memory unit 204 furthermore stores a heating profile used for heating of the stick-type substrate 210 constituting the aerosol source. The heating profile is a data file stipulating temporal changes in a target temperature after the start of heating.

The memory unit 204 stores one heating profile in this embodiment.

It should be noted that the heating profile will be referred to as both a "control profile" and a "control sequence".

The information stored in the memory unit 204 additionally includes information relating to control of electronic components, for example. The information relating to control includes information relating to inhalation by the user, such as number of inhalations, times of inhalation, and cumulative inhalation time. In other words, the memory unit 204 stores a user inhalation behavior history and an operating history.

The communication unit 205 is a communication interface for implementing communication between the main body device 20 and another device. The communication unit 205 communicates with other devices by means of a system based on any wired or wireless communication standard. The communication standards referred to here include wireless LAN, wired LAN, Wi-Fi (registered trademark), and Bluetooth (registered trademark), for example.

For example, the communication unit 205 sends the information relating to user inhalation to a smartphone.

Furthermore, the communication unit 205 downloads, from a server, update programs and profiles stipulating changes in temperature of the heating unit 207 in a heating mode.

The control unit 206 functions as an arithmetic processing device and a control device, controlling operations of the main body device 20 in accordance with various programs.

Control signals are sent through signal lines different from the power source line. For example, communication in the main body device 20 employs a serial communication method such as an inter-integrated circuit (= I2C) communication method, a serial peripheral interface (= SPI) communication method, or a universal asynchronous receiver transmitter (= UART) communication method.

The control unit 206 is realized by means of an electronic circuit such as a central processing unit (= CPU), a microprocessing unit (= MPU), a graphical processing unit (= GPU), an application-specific integrated circuit (= ASIC), a field programmable gate array (= FPGA), or a digital signal processor (= DSP).

The control unit 206 may also include a read only memory (= ROM) for storing programs and computation parameters, etc., and a random access memory (= RAM) for temporarily storing suitably changing parameters, etc.

The control unit 206 executes various types of processing and control through execution of programs.

The processing and control referred to here include, for example: rewriting of heating profiles; supply of electricity from the power source unit 201 to other electronic components; charging of the power source unit 201; detection of information by the sensor unit 202; notification of information by the notification unit 203; storage and reading of information by the memory unit 204; and sending/receiving of information by the communication unit 205.

The control unit 206 additionally controls processing, etc. based on input of information to the electronic components and information output from the electronic components.

Furthermore, the control unit 206 also has a function for identifying a functional type of the front panel 10 attached to the main body device 20, and for implementing processing and control correspondingly with a result of the identification.

The holding portion 209 is a substantially cylindrical container. In this embodiment, a space inside the holding portion 209 defined by an inner wall and a bottom face will be referred to as an internal space 209A. The internal space 209A is substantially columnar.

An opening 209B allowing the internal space 209A to communicate with the exterior is provided in the holding portion 209. The stick-type substrate 210 is inserted into the internal space 209A from the opening 209B. The stick-type substrate 210 is inserted until a tip end thereof touches a bottom portion 209C.

The stick-type substrate 210 is only partially accommodated in the internal space 209A. A state in which the stick-type substrate 210 is accommodated in the internal space 209A will be referred to as the stick-type substrate 210 being held in the internal space 209A.

The inner diameter of at least part of the holding portion 209 in an axial direction thereof is formed so as to be smaller than the outer diameter of the stick-type substrate 210.

An outer circumferential surface of the stick-type substrate 210 inserted into the internal space 209A is therefore subjected to pressure from the inner wall of the holding portion 209. The stick-type substrate 210 is held in the internal space 209A by means of this pressure.

The holding portion 209 also has a function for defining a flow path for air passing through the stick-type substrate 210. An air inflow hole which is an inlet for air into the flow path is disposed in the bottom portion 209C, for example. Moreover, the opening 209B serves as an air outflow hole which is an outlet for the air.

In this embodiment, only part of the stick-type substrate 210 is held in the holding portion 209, with the remainder protruding outside from an enclosure. The part which is held in the holding portion 209 will be referred to below as a substrate portion 210A, and the part protruding from the enclosure will be referred to below as a mouthpiece portion 210B.

The aerosol source is accommodated in at least the substrate portion 210A. The aerosol source is a substance which is atomized by heating so as to generate an aerosol.

Other than shredded tobacco, the aerosol source contains a processed product obtained by molding a tobacco raw material into a granular form, a sheet form or a powder form, or another tobacco-derived substance.

In addition, the aerosol source may also contain a non-tobacco-derived substance produced from a plant other than tobacco, such as mint or herb. The aerosol source may contain a flavoring component such as menthol, for example.

When the main body device 20 is a medical inhaler, the aerosol source may contain a drug to be inhaled by a patient. It should be noted that the aerosol source is not limited to a solid, and may equally be a polyhydric alcohol such as glycerol or propylene glycol, or may be a liquid such as water, for example.

At least part of the mouthpiece portion 210B is held in the user's mouth during inhalation.

When the user inhales with the mouthpiece portion 210B held in the mouth, air flows into the internal space 209A from the air inflow hole. The air which has flowed in reaches the user's mouth after passing through the internal space 209A and the substrate portion 210A. The air reaching the user's mouth contains the aerosol generated by the substrate portion 210A.

The heating unit 207 is formed by a heater or other heat-generating element. The heating unit 207 is formed by any material such as a metal or polyimide. The heating unit 207 is constructed in the form of a film, for example, and fitted to the outer circumferential surface of the holding portion 209.

The aerosol source contained in the stick-type substrate 210 is heated and atomized by the heat generated by the heating unit 207. The atomized aerosol source is mixed with air, etc., and an aerosol is generated.

In fig. 7, the outer circumferential region of the stick-type substrate 210 is initially heated, with the range of heating steadily moving toward the center.

Atomization of the aerosol source therefore starts from the outer circumferential region of the stick-type substrate 210 and steadily moves toward the center.

The heating unit 207 generates heat by means of electrical supply from the power source unit 201. Electrical supply to the heating unit 207 is permitted when predetermined user input is detected via the sensor unit 202, for example. The user input as referred to here includes operation of the shutter 30 (see fig. 1) and/or of the button 20B (see fig. 4). However, electricity is supplied to the heating unit 207 on the assumption that the front panel 10 (see fig. 1) is attached to the main body device 20. By attaching the front panel 10, the temperature transmitted to the user's hand can be reduced as compared to when the front panel 10 is not attached.

Moreover, inhalation by the user becomes possible when the temperature of the stick-type substrate 210 heated by means of the heating unit 207 reaches a predetermined temperature. Inhalation of the aerosol by the user is detected by means of the flow rate sensor, etc. in the sensor unit 202 and saved in the memory unit 204.

Electrical supply to the heating unit 207 is stopped when predetermined user input is subsequently detected by the sensor unit 202. It should be noted that it is also possible to adopt a method in which electricity is supplied to the heating unit 207 during a period in which inhalation by the user is detected by the sensor unit 202, and electrical supply to the heating unit 207 is stopped when inhalation by the user is no longer detected by the sensor unit 202.

Furthermore, in the example of fig. 7, the heating unit 207 is disposed outside the stick-type substrate 210, but it is equally possible for the heating unit 207 to be a blade-like metal piece which is inserted into the stick-type substrate 210 for use, or for the heating unit 207 to be a metal piece built into the stick-type substrate 210. When a metal piece acting as the heating unit 207 is built into the stick-type substrate 210, an induction heating coil should be arranged around the holding portion 209.

The heat insulating portion 208 is a member for reducing propagation of heat generated by the heating unit 207 to the surrounding area. The heat insulating portion 208 is therefore disposed so as to cover at least the outer circumferential surface of the heating unit 207.

For example, the heat insulating portion 208 is configured by a vacuum insulating material or an aerogel insulating material, etc. A vacuum insulating material is a heat insulating material in which a state of high vacuum is created by wrapping glass wool and silica (silicon powder), etc. in a resin film, for example, so that heat conduction by gas is as close as possible to zero.

### <Processing Operation Example>

An example of processing operations implemented by the control unit 206 (see fig. 7) in the main body device 20 (see fig. 7) will be described below.

### <Attachment Detection Operation>

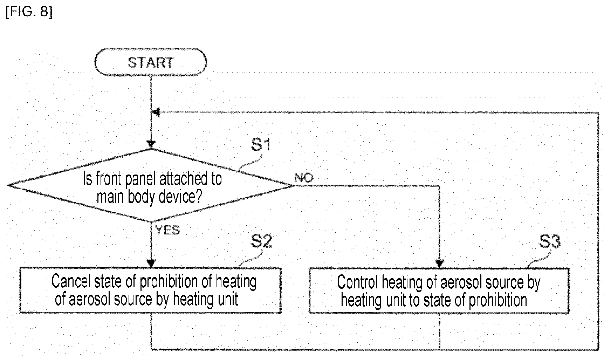

Fig. 8 is a flowchart illustrating an example of an operation to detect attachment of the front panel 10 which is implemented by the control unit 206 in the main body device 20. This operation is implemented not only before the start of heating by the heating unit 207 (see fig. 7), but also after heating has started, and is constantly implemented in the background. Note that the symbol "S" in the drawings means "step".

The control unit 206 first of all determines whether or not the front panel 10 (see fig. 1) is attached to the main body device 20 (see fig. 1) (step 1).

When the front panel 10 is attached to the main body device 20, an affirmative result is obtained in step 1. On the other hand, when the front panel 10 is removed from the front face of the main body device 20, a negative result is obtained in step 1. Attachment/detachment of the front panel 10 is determined on the basis of an output signal from the Hall IC.

When an affirmative result is obtained in step 1, the control unit 206 cancels the state of prohibition of heating of the aerosol source by the heating unit 207 (step 2).

However, canceling the state of prohibition of heating is different from heating being started. Heating of the stick-type substrate 210 (see fig. 7) constituting the aerosol source is started by a long press of 1 second or greater of the button 20B (see fig. 4) from above the front panel 10.

When a negative result is obtained in step 1, the control unit 206 controls heating of the aerosol source by the heating unit 207 to the state of prohibition (step 3). This makes it possible to prevent heating of the aerosol source while the front panel 10 is not attached.

When step 2 or step 3 is implemented, the control unit 206 repeatedly returns to step 1 to determine whether or not the front panel 10 is attached to the main body device 20.

This attachment detection operation ensures that the user is not directly touching the main body device 20 during a heating operation.

### <Identifying Functional Type of Front Panel>

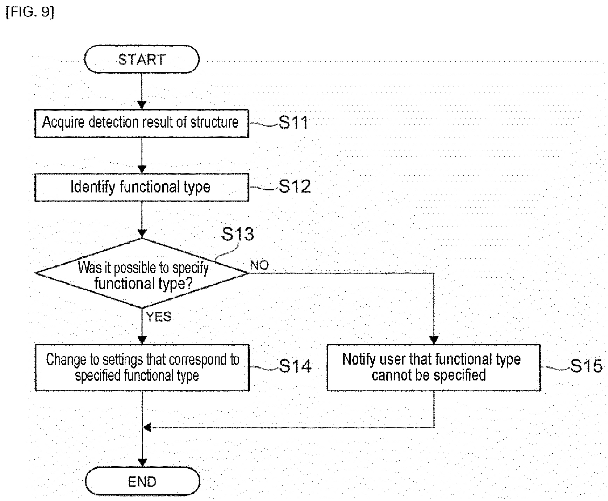

Fig. 9 is a flowchart illustrating an example of a process for identifying a functional type of the front panel, implemented by the control unit 206 (see fig. 7) of the main body device 20 (see fig. 7) of embodiment 1.

The processing shown in fig. 9 is launched at a timing at which attachment of the front panel 10 has been detected by means of an output signal from the Hall IC, for example. Moreover, the processing shown in fig. 9 may equally be launched at a timing at which a specific user operation has been received. Specific operations as referred to here include, for example: opening/closing of the shutter 30 multiple consecutive times (e.g., twice), operation of the button 20B multiple consecutive times (e.g., twice), and a reset operation performed by a long press (e.g., 5 seconds or more) of the button 20B.

When the processing shown in fig. 9 starts, the control unit 206 acquires detection results of the structure 102 (step 11).

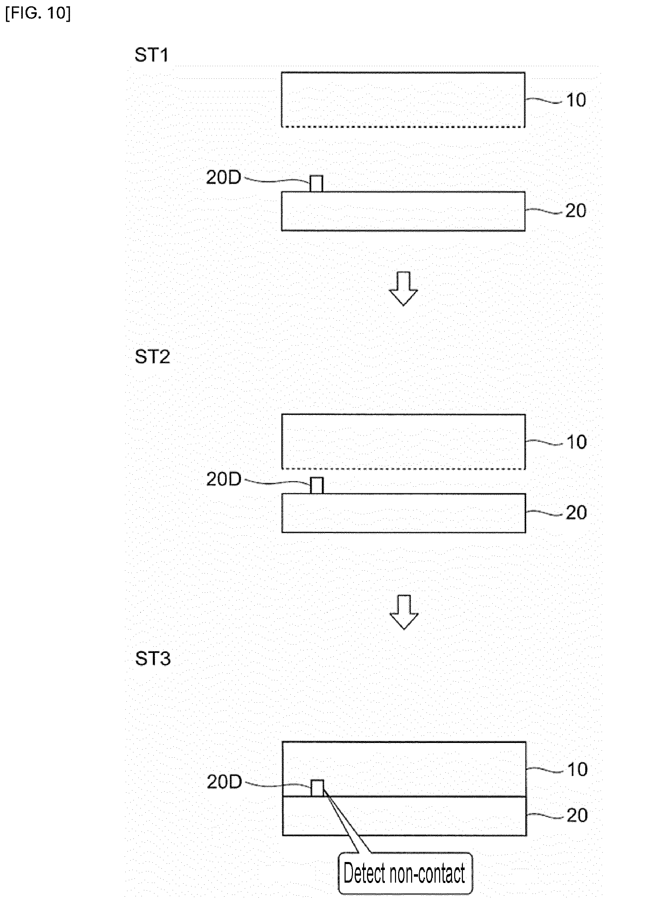

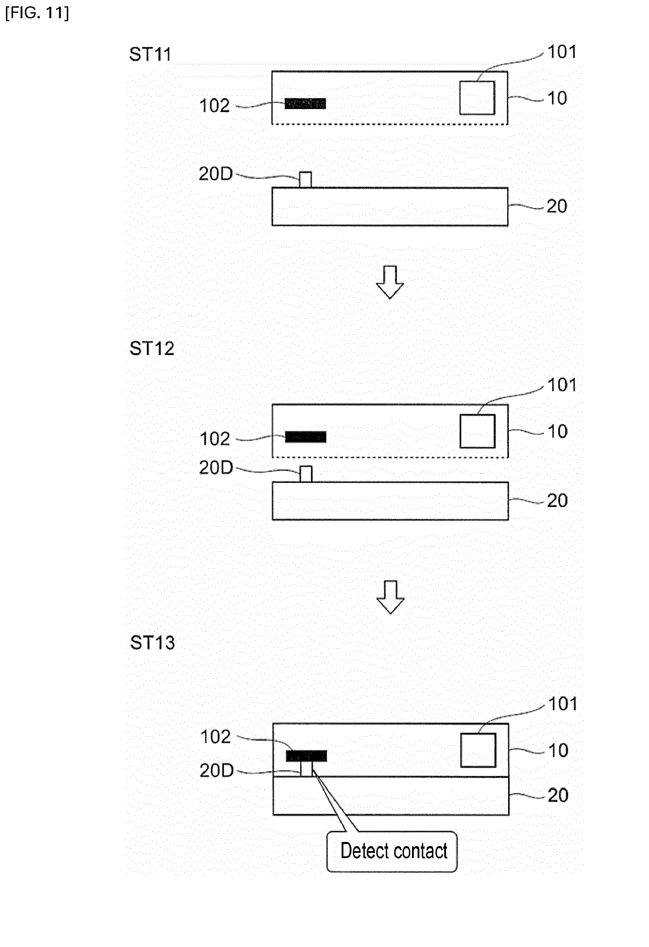

The detection results here are obtained for either fig. 10 or fig. 11.

Fig. 10 is a diagram illustrating the attachment of a basic panel (front panel 10 shown in fig. 5) to the main body device 20 and non-detection of the structure 102.

Three states ST1 to ST3 are shown in fig. 10.

State ST1 indicates a state in which the attachment of the front panel 10 to the main body device 20 is started, state ST2 indicates a state just before the front panel 10 is attached to the main body device 20, and state ST3 indicates a state in which the front panel 10 is attached to the main body device 20. Note that state ST3 is also a state in which the Hall IC detects attachment of the front panel 10.

For state ST3, there is no object in contact with the sensor 20D. As such, non-contact is detected as the detection result.

Fig. 11 is a diagram illustrating the attachment of the front panel 10 (the front panel 10 in fig. 6), to which a primary battery 101 can be attached, on the main body device 20, and detection of the structure 102.

Three states ST11 to ST13 are shown in fig. 11.

State ST11 indicates a state in which the attachment of the front panel 10 to the main body device 20 is started, state ST12 indicates a state just before the front panel 10 is attached to the main body device 20, and state ST13 indicates a state in which the front panel 10 is attached to the main body device 20. State ST13 is also a state in which the Hall IC detects attachment of the front panel 10.

For state ST13, the sensor 20D and the structure 102 are in contact. As such, contact is detected as the detection result.

The description will return to the description of fig. 9.

The control unit 206 with the detection result identifies the functional type (step 12). In the case of the present embodiment, based on the detection result of the structure 102, one of two types is identified.

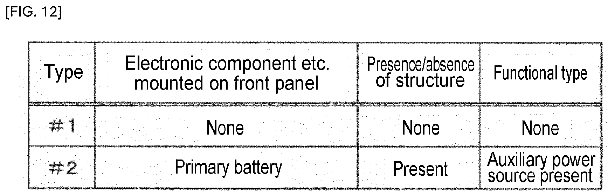

Fig. 12 is a table illustrating the relationship between the functional types and the presence or absence of the structure 102 in embodiment 1. This table is stored in the memory unit 204 (see fig. 7), for example. Note that the structure of the table is not limited to the data structure shown in fig. 12.

In the table shown in fig. 12, information pertaining to "electronic component etc. mounted on the front panel", "presence or absence of a structure" and "functional type" are recorded for each of the types #1 and #2.

For example, type #1 corresponds to the so-called basic panel. For this reason, "None" is recorded for each item. Functional type "None" means "no" additional functionality to the basic functions used for decoration, protection of the main body, etc.

On the other hand, type #2 is the front panel 10 in which the primary battery 101 can be mounted. As such, the primary battery 101 is described as an electronic component mounted on the front panel 10 and the structure 102 is recorded as "present". Furthermore, "with auxiliary power source" is recorded as the functional type. In the case of fig. 12, each piece of information is represented in text, but may equally be represented by numbers and symbols recognizable by the control unit 206.

The description will return to the description of fig. 9.

The control unit 206 then determines whether or not the functional type can be specified (step 13). In the case of the present embodiment, the identification of the functional type is based solely on the presence or absence of the structure 102, but when the functional type is identified by a combination of a plurality of elements, it could occur that a plurality of combinations are satisfied at the same time or none of the combinations are satisfied. For this reason, step 13 is provided in the processing example shown in fig. 9.

If the functional type is specified, an affirmative result is obtained in step 13. In this case, the control unit 206 changes the settings according to the specified functional type (step 14).

If the functional type is "with auxiliary power source", the control unit 206 changes the setting to switch to power supply from the primary battery 101 of the front panel 10 when the remaining capacity of a power source unit 201, which is the mains power, for example, falls below a threshold value.

Furthermore, if the functional type is "with auxiliary power source", the control unit 206 changes the setting to make it possible to select a heating profile in which the generated amount of aerosol during inhalation increases (hereinafter also referred to as "increased amount profile"), for example.

The control unit 206 may automatically change the heating profile to the increased amount profile when the functional type is "with auxiliary source", and if the functional type is "none", the control unit may automatically change the heating profile to a heating profile at which the generated amount of aerosol during inhalation is a reference value (hereinafter also referred to as "standard profile").

The control unit 206 may also enable a setting to measure and display the remaining capacity of the primary battery 101 that is the auxiliary power source, in addition to the remaining capacity of the power source unit 201 that is the mains power source, when the functional type is "with auxiliary source". The measurement and display here may be individual, or the indication may be a total value of the remaining capacity.

Note that if the functional type is "none", the control unit 206 is set to a state in which only basic functions are executed, for example. That is, the heating profile is essentially set to the standard profile. However, if the increased amount profile is provided, a switch from the standard profile to the increased amount profile is possible by selection by the user.

In contrast, if the functional type is not specified, a negative result is obtained in step 13. In this case, the control unit 206 informs the user that the functional type cannot be specified (step 15). The notification to the user may use, for example, an LED 20A (see fig. 4) or other light emitting device, display device, sound output device, vibration device, etc.

### <Summary>

In the present embodiment, the control unit 206 automatically identifies which of the front panel 10 in which the battery can be mounted or the basic front panel 10 in which the battery is not mounted is mounted on the main body device 20. The control unit 206 then automatically changes the settings in the main body device 20 depending on the identified functional type.

In this manner, the user can simply attach the front panel 10 to the main body device 20 to complete the setting according to the functional type of the front panel 10. That is, with the attachment of the front panel 10, a change in the processing operation implemented by the aerosol generating device 1 (main body device 20) can be achieved. In other words, a cooperation operation between the front panel 10 and the aerosol generating device 1 (main body device 20) is easily achieved.

It should be noted that, although the present embodiment has described a case where there is one structure 102 provided on the rear face of the front panel 10, there may be a plurality of detection positions for detecting the presence or absence of the structure 102 . For example, a plurality of sensors 20D may be arranged to detect the presence or absence of the structure 102 in the main body device 20. In this case, for example, if the number of sensors 20D is N, a functional identification of 2 to the N power is possible.

The sensor 20D in the present embodiment identifies the functional type of the front panel 10 attached to the main body device 20 by the presence or absence of contact with the structure 102, but may identify the functional type by a difference in the thickness of the structure 102 or a difference in the height of the contact surface. The sensor 20D may use a capacitive sensor, an optical sensor, an optical color sensor, an RFID reader, an NFC reader, etc., to identify the functional type of the front panel 10 in a non-contact manner.

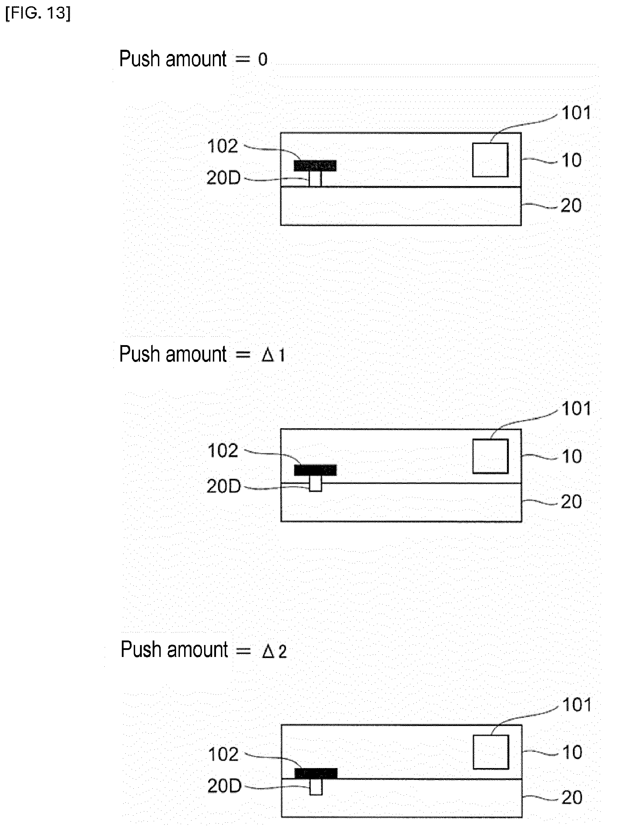

Fig. 13 is a diagram illustrating an example for detecting a difference in the push amount of a detection pin on a sensor 20D side from contact with the structure 102. In the case of fig. 13, there are three types of push amounts : 0, Δ1, and Δ2. As such, identification of three functional types is possible.

It should be noted that a displacement sensor may be used as the sensor 20D to measure the distance to the structure 102, and the functional type may be identified by the difference in the measured distance.

In addition, a magnetic material may be provided on the rear face of the front panel 10 instead of the structure 102, and the presence or absence of the magnetic material may be detected by the output of the Hall IC provided at the corresponding position. In this case, the presence or absence of the magnetic material is associated with the functional type. Furthermore, the pattern (arrangement and number) of the arrangement of the magnetic material may allow the identification of a plurality of functional types. The arrangement pattern of the magnetic material is also an example of a structural feature.

In any case, a simple mechanism allows the functional type of the front panel 10 to be identified by the main body device 20.

### <Embodiment 2>

In the present embodiment, a case in which the functional type of the front panel 10 is made notifiable by communication between the front panel 10 and the main body device 20 will be described.

In the present embodiment, the front panel 10 is provided with the necessary wiring and electronic components for communication with the main body device 20. As such, the front panel 10 does not require the installation of the structure 102 for the purpose of representing the functional type.

Furthermore, in the case of the present embodiment, the main body device 20 also does not require the installation of the sensor 20D that detects the presence or absence of the structure 102 on the front panel 10 side.

Other hardware and functional configurations are essentially similar to embodiment 1.

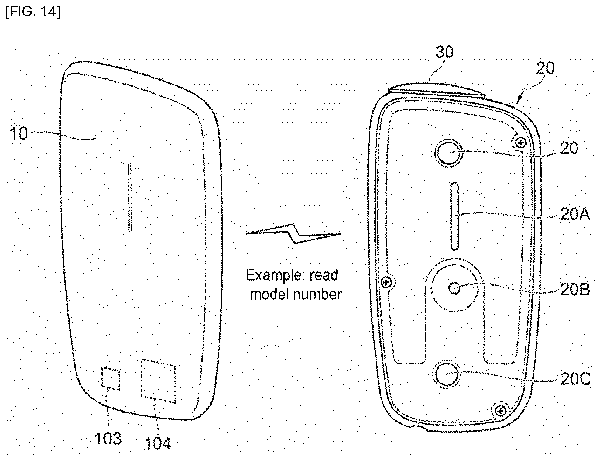

Fig. 14 is a diagram illustrating an example of communication between the front panel 10 and the main body device 20 in embodiment 2. Corresponding reference signs are given in fig. 14 for parts which correspond to those of fig. 1 and 4.

In fig. 14, communication using Bluetooth^{®} is envisaged. For this reason, the front panel 10 has been removed from the main body device 20. The front panel 10 here is an example of the front panel 10 to be attached to the main body device 20.

Communication with the front panel 10 attached to the main body device 20 may equally be envisaged. Communication between the front panel 10 and the main body device 20, when attached, may be wired communication by contacting or connecting communication terminals, or may be near field communication (NFC).

In the case of fig. 14, the information necessary for specifying the functional type is recorded in the IC chip 103. The IC chip 103 may be a contact type or contactless.

The information recorded in the IC chip 103 is read out from the main body device 20. The information needed to specify the functional type includes, for example, the model number, serial number, and model name of the front panel 10, the type and name of the electronic component installed, and a number representing the functional type.

Incidentally, the type and number of electronic components 104 mounted on the front panel 10 vary.

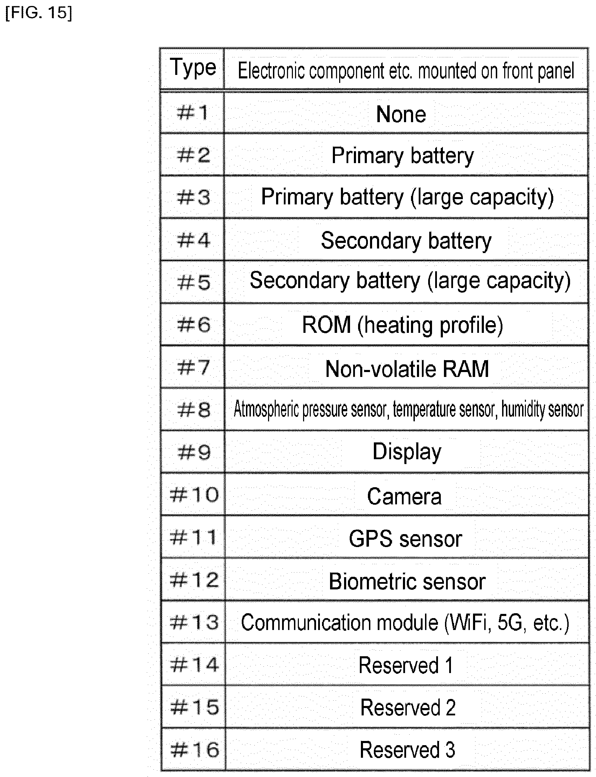

Fig. 15 is a diagram illustrating examples of correspondence between functional types and electronic components mounted on the front panel 10.

In the case of fig. 15, the functional type is represented in 4 bits, but it is also possible to represent the functional type in 5 bits or more.

In the case of the present embodiment, any of #1 to #16 representing the functional type is recorded on the IC chip 103 (see fig. 14) described previously.

Type #1 corresponds to the basic panel. For this reason, the electronic component 104 is "none".

Type #2 represents the front panel 10 with a primary battery 101 mounted, and type #3 represents the front panel 10 with a high capacity primary battery 101 mounted. For example, the front panel 10 with one button battery is of type #2 and the front panel 10 with two button batteries is of type #3.

Similarly, type #4 represents the front panel 10 with a secondary battery mounted, and type #5 represents the front panel 10 with a high capacity secondary battery mounted.

Type #6 represents the front panel 10 with a ROM storing a heating profile mounted. Note that it is also possible to treat the front panel as a different type of front panel 10 if the content of the heating profile is different. The heating profile here may be the increased amount profile, or a heating profile in which the generated amount of aerosol during inhalation is less than the reference value (hereinafter also referred to as "reduced amount profile"). Furthermore, the type of heating profile stored in the front panel 10 may not be limited to one, and may be a plurality. For example, the front panel 10 may store the increased amount profile and the reduced amount profile.

If the front panel 10 is fitted with a ROM storing the heating profile, the control unit 206 changes to a setting that allows selection of the heating profile, for example.

The control unit 206 may change the setting to preferentially apply the heating profile stored in the attached front panel 10. If the heating profile stored in the front panel 10 is prioritized, the user can change the heating profile used to heat the aerosol source simply by replacing the front panel 10.

The control unit 206 may also overwrite or additionally record the heating profile stored in the front panel 10 in the memory unit 204 (see fig. 7) of the main body device 20. However, the additional recording is limited to a case in which the memory unit 204 supports the recording of a plurality of heating profiles. In this case, even after the front panel 10 has been removed, the main body device 20 is able to continue inhalation with the heating profile read from the removed front panel 10.

It is also possible that the heating profile stored in the front panel 10 is read-only and is a setting used for heating the aerosol only if selected by the user.

Type #7 represents the front panel 10 fitted with a non-volatile RAM. The data stored in the non-volatile RAM is optional, but may be limited to the heating profile. For example, non-volatile RAM may be used as a backup area for the memory unit 204 of the main body device 20. Furthermore, if the number of heating profiles that can be written to the memory unit 204 of the main body device 20 is two, the third or later heating profile may be written to the non-volatile RAM. The control unit 206 that detects attachment of the front panel 10 fitted with the non-volatile RAM to the main body device 20 sets the non-volatile RAM as an extended memory of the memory unit 204.

Type #8 represents the front panel 10 fitted with an atmospheric pressure sensor, a temperature sensor, and a humidity sensor. In the case of fig. 15, three types of sensors are mounted, but only one of the sensors may be mounted, or other sensors may be mounted. When it is possible to change the heating profile, such as according to the use environment, the control unit 206 may switch the heating profile to be applied based on atmospheric pressure and other information acquired from the front panel 10.

Type #9 represents the front panel 10 fitted with a display. Note that it is also possible to treat the front panel as a different type of front panel 10 when the size and shape of the display is different. When the front panel 10 fitted with a display is attached to the main body device 20, the control unit 206 changes the display to the output destination of the information instead of the LED 20A. Depending on the size and arrangement of the display, it may be possible to notify information using both the LED 20A and the display.

Type #10 represents the front panel 10 fitted with a camera. When the front panel 10 fitted with a camera is attached to the main body device 20, the control unit 206 is able to identify a brand, etc. from the external appearance of the container containing the stick-type substrate 210 (see fig. 7) imaged by the camera mounted on the front panel 10 or the external appearance of the stick-type substrate 210, and select a heating profile suitable for the identified brand, etc.

Type #11 represents the front panel 10 fitted with a GPS (= Global Positioning System) sensor. When a front panel 10 fitted with the GPS sensor is attached, the control unit 206 enables a processing function using position information received from the GPS sensor. For example, a heating profile that is based on the region or country corresponding to the detected position information is selected as the heating profile of the aerosol source. Furthermore, if the position detected by the GPS sensor falls in a prohibited space or a prohibited area for inhalation, for example, the control unit 206 performs processing such as disabling the heating operation of the aerosol source.

Type #12 represents the front panel 10 fitted with a biometric sensor. The sensor includes, for example, a heart rate sensor, a pulse sensor, a blood oxygen saturation sensor, and a blood flow sensor. The front panel 10 may be equipped with all of the sensors illustrated, only one of the sensors, or may be equipped with undescribed sensors. When the front panel 10 fitted with the biometric sensor is attached, the control unit 206 performs processing such as disabling a heating operation of the aerosol source if a poor physical condition is estimated by the measured biometric information (e.g., if an abnormal value is measured).

Type #13 represents a front panel 10 fitted with a communication module. The communication module here assumes a communication function with an external network such as WiFi or a mobile communication system (e.g., 5G). When the front panel 10 fitted with the communication module is attached, the control unit 206 communicates, for example, with a server operated by a supplier of the aerosol source or a supplier of the main body device 20, and implements processing to request provision of advertising, guidance, contact, warnings, or other services to a user of the main body device 20.

Incidentally, in the case of fig. 15, #14 to #16 are reserve regions.

Furthermore, although typical electronic components 104 were illustrated in fig. 15, a plurality of these electronic components 104 may be mounted on one front panel 10. For example, the secondary battery of type #4, the ROM of type #6 and the display of type #9 may be mounted on one front panel 10.

### <Specific example>

In the following, specific examples of the cooperation operation implemented when the front panel 10 fitted with a ROM and a secondary battery as electronic components 104 is attached to the main body device 20 are described.

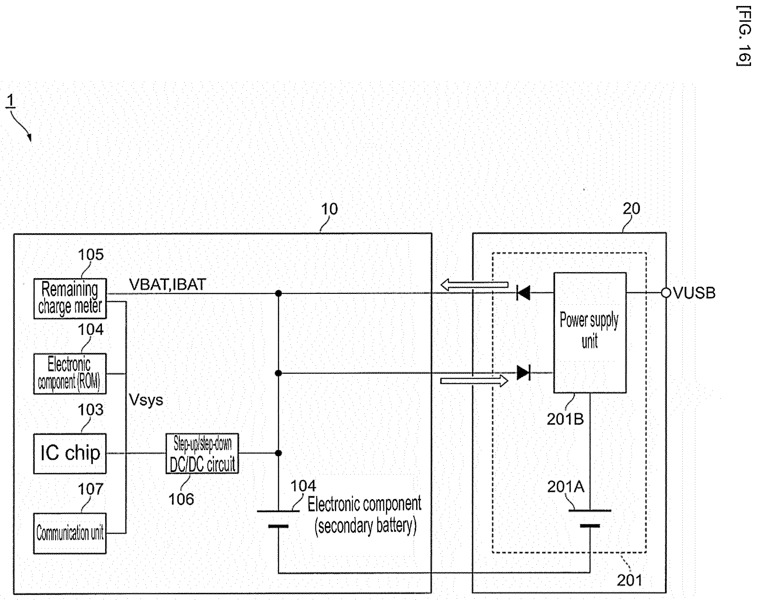

Fig. 16 is a diagram schematically showing connection relationships of a power source system circuit in the front panel 10 and the main body device 20.

In the case of fig. 16, the front panel 10 is provided with an IC chip 103 recording functional types, electronic components 104 (secondary battery and ROM), a remaining charge meter 105 for measuring the remaining capacity of the secondary battery, a step-up/step-down DC/DC circuit 106, and a communication unit 107 notifying the measured remaining capacity to the control unit 206 of the main body device 20.

The secondary battery as the electronic component 104 is, for example, a lithium-ion secondary battery.

The remaining charge meter 105 is a circuit that calculates the remaining amount of the secondary battery based on the power supply current IBAT and the power supply voltage VBAT that appear in the power source line of the secondary battery, etc. It should be noted that the calculation of the remaining amount by the remaining charge meter 105 may, for example, be implemented at a predetermined cycle or timing, or may only be implemented when instructed by the control unit 206 of the main body device 20. The calculated remaining amount is notified to the control unit 206.

The step-up/step-down DC/DC circuit 106 is a circuit for generating a system power source Vsys of 3.3 V from the output voltage of the secondary battery. The generated system power source Vsys is supplied to the IC chip 103, the ROM as the electronic component 104, the remaining charge meter 105, and the communication unit 107. In the present embodiment, the heating profile is recorded in the ROM.

The communication unit 107 is a Bluetooth module.

On the other hand, the power source unit 201 of the main body device 20 consists of a secondary battery 201A and a power supply unit 201B.

The secondary battery 201A is, for example, a lithium-ion battery.

The power supply unit 201B switches the supply path of power and performs a conversion of voltage levels, depending on the operation mode.

The power supply unit 201B generates a system power source Vsys for the electronic components in the main body device 20. Furthermore, the power supply unit 201B outputs e.g., 5 V to the power source line to which the LED 20A (see fig. 4) is connected, and outputs e.g., 4.2 V to the power source line to which the heating unit 207 is connected.

Furthermore, when the secondary battery 201B is charged by an external power source, the power supply unit 201B outputs e.g., 4.2 V to the power source line connected to the secondary battery 201A.

The external power source as referred to here includes a mains power source and a mobile battery, and also further includes the secondary battery on the front panel 10.

A USB cable is used for supplying electricity from a mains power source or a mobile battery, so a corresponding electrical supply terminal is denoted by VUSB in fig. 16.

The power supply unit 201B is also connected with a power source line for charging the secondary battery of the front panel 10 and a power source line for receiving power from the secondary battery of the front panel 10.

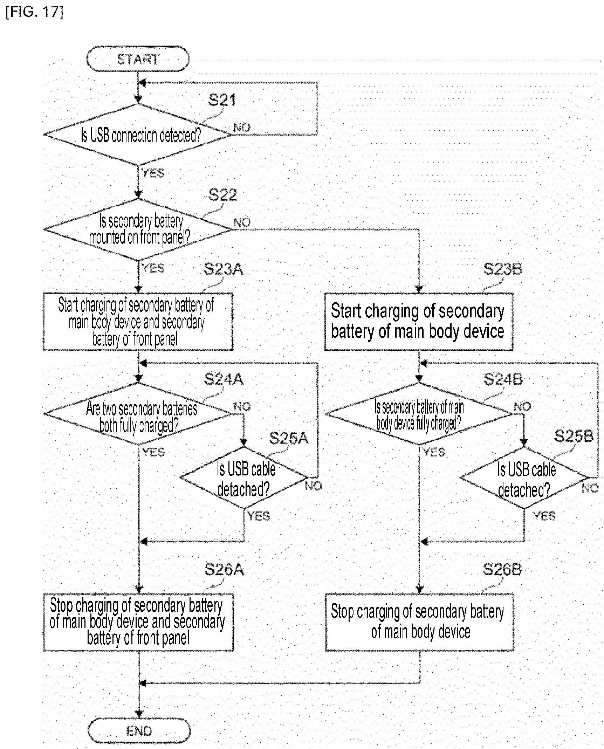

Fig. 17 is a flowchart illustrating an example of a USB charging operation implemented by the control unit 206.

The control unit 206 first of all determines whether or not a USB connection has been detected (step 21).

A negative result is obtained in step 21 when a USB connection is not detected. In this case, the control unit 206 repeats the determination of step 21.

Meanwhile, an affirmative result is obtained in step 21 when a USB connection has been detected. In this case, the control unit 206 determines whether or not the secondary battery is mounted on the front panel 10 (step 22).

An affirmative result is obtained in step 22 when the secondary battery is mounted on the front panel 10. In this case, the control unit 206 starts charging of the secondary battery in the main body device 20 and of the secondary battery on the front panel 10 (step 23A). Note that the actual charging may employ a process in which either one of the secondary battery 201A in the main body device 20 and the secondary battery 101A on the front panel 10 is charged to full capacity first, then the other secondary battery is charged to full capacity. Charging of the secondary battery 201A in the main body device 20 and the secondary battery 101A on the front panel 10 may equally be performed in parallel.

The control unit 206 then determines whether or not both of the two secondary batteries are fully charged (step 24A).

A negative result is obtained in step 24A if either of the two secondary batteries is not fully charged. Meanwhile, an affirmative result is obtained in step 24A when both of the two secondary batteries are fully charged.

If a negative result is obtained in step 24A, the control unit 206 determines whether or not the USB cable has been detached (step 25A).

A negative result is obtained in step 25A if the USB cable is still attached. In this case, the control unit 206 returns to step 24A.

Meanwhile, an affirmative result is obtained in step 25A if the USB cable has become detached during charging.

If an affirmative result is obtained in step 24A or if an affirmative result is obtained in step 25A, the control unit 206 stops charging of the secondary battery in the main body device 20 and of the secondary battery on the front panel 10 (step 26A). After this, the control unit 206 terminates the USB charging operation.

The description will return to the determination in step 22.

A negative result is obtained in step 22 when the secondary battery is not mounted on the front panel 10 (including not only a case in which a battery is not mounted, but also a case in which the battery which is mounted is the primary battery). In this case, the control unit 206 starts charging of the secondary battery in the main body device 20 (step 23B).

The control unit 206 then determines whether or not the secondary battery in the main body device 20 is fully charged (step 24B).

A negative result is obtained in step 24B if the secondary battery is not fully charged. Meanwhile, an affirmative result is obtained in step 24B if the secondary battery is fully charged.

If a negative result is obtained in step 24B, the control unit 206 determines whether or not the USB cable has been detached (step 25B).

A negative result is obtained in step 25B if the USB cable is still attached. In this case, the control unit 206 returns to step 24B.

Meanwhile, an affirmative result is obtained in step 25B if the USB cable has become detached during charging.

If an affirmative result is obtained in step 24B or if an affirmative result is obtained in step 25B, the control unit 206 stops charging of the secondary battery in the main body device 20 (step 26B).

After this, the control unit 206 terminates the USB charging operation.

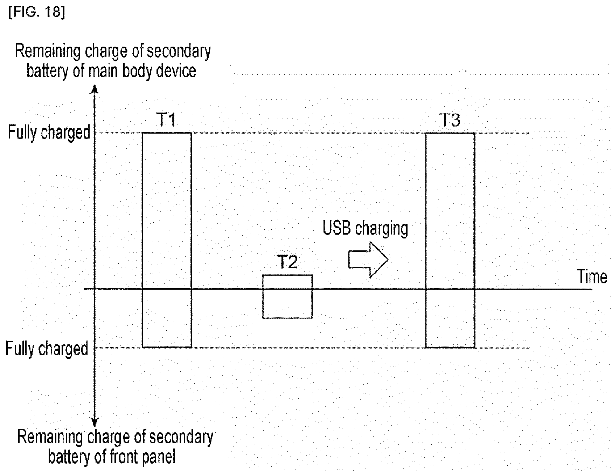

Fig. 18 is a diagram illustrating the USB charging operation.

The horizontal axis in the drawing denotes time, the top half of the vertical axis denotes remaining charge in the secondary battery in the main body device 20, and the bottom half of the vertical axis denotes remaining charge in the secondary battery in the front panel 10.

In fig. 18, the secondary battery on the front panel 10 and the secondary battery in the main body device 20 are both fully charged in an initial state T1.

At a time point T2, the remaining charge in the secondary battery on the front panel 10 and the secondary battery in the main body device 20 has fallen below full charge in both cases. USB charging is started when the USB cable is connected in this state.

At T3 at the end of USB charging, the secondary battery on the front panel 10 and the secondary battery in the main body device 20 both return to fully charged.

### <Summary>

In the case of the present embodiment, the information of the electronic component 104 mounted on the front panel 10 is read out through communication with the main body device 20. The number of combinations of electronic components and types of front panel 10 that can be identified by the main body device 20 can therefore be increased more easily than in embodiment 1. For example, the adoption of new electronic components or the release of a new front panel 10 can be easily accommodated by updating the firmware or updating the correspondence relationships illustrated in fig. 15.

In the case of the present embodiment, the main body device 20 is able to read or specify the functional type of the front panel 10 through communication, and thus more detailed information can be obtained than in embodiment 1.

### <Embodiment 3>

In the present embodiment, a case in which a magnetic pattern representative of the functional type of the front panel 10 is recorded will be described.

In the present embodiment, there is no need to provide the special structure 102 (see fig. 6) on the front panel 10 and the main body device 20 as in embodiment 1, and there is no need to provide the communication unit 107 (see fig. 16) on the front panel 10 as in embodiment 2.

Therefore, the basic hardware configuration and functional configuration are therefore the same as in embodiment 1.

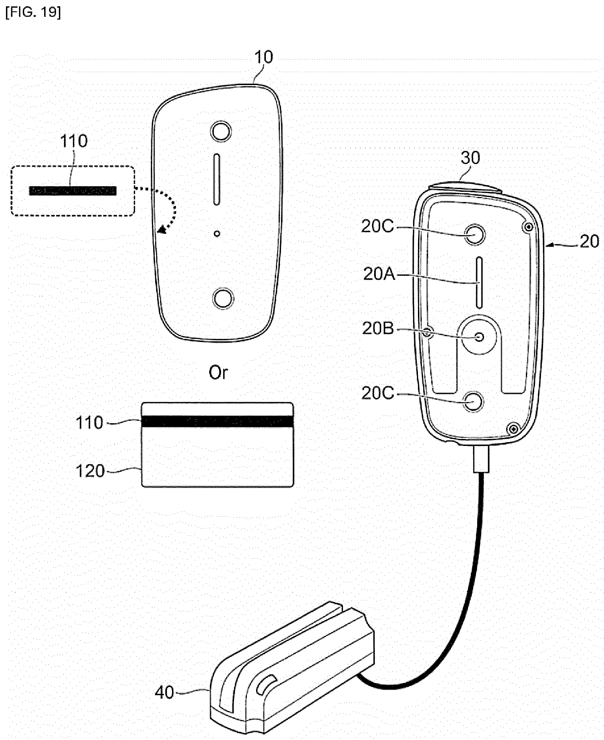

Fig. 19 is a diagram illustrating a method for reading a functional type of the front panel in embodiment 3. Corresponding reference signs are given in fig. 19 for parts which correspond to those of fig. 4 and 5.

In the case of the present embodiment, information about the functional type specified by the electronic component or the combination of electronic components mounted on the front panel 10 is recorded as a magnetic pattern.

A magnetic stripe 110 on which the magnetic pattern is recorded may be attached to the front panel 10 or attached to a magnetic card 120 that is an accessory to the front panel 10.

When attaching the magnetic stripe 110 to the front panel 10, the magnetic stripe 110 is attached to the peripheral edge or the like of the rear face of the front panel 10.

In the case of fig. 19, the magnetic reader 40 and the main body device 20 are connected by a USB cable and the magnetic pattern recorded in the magnetic stripe of the front panel 10 or the magnetic card 120 is read. However, a magnetic reader 40 may be attached to a part of the main body device 20.

Note that, if the shape of the front panel 10 is not suitable for reading magnetic stripes, the magnetic card 120 is adopted.

### <Summary>

In the case of the present embodiment, the main body device 20 can obtain information of the electronic components 104 mounted on the front panel 10 by reading the magnetic pattern. Furthermore, the magnetic reader 40 used for reading the magnetic pattern can be used by connecting to the USB connector 21, and thus there is no need to change the design or the like of the main body device 20. As such, a simple mechanism allows the functional type of the front panel 10 to be identified by the main body device 20.

Furthermore, as in embodiment 2, the foregoing configuration allows for more detailed information to be obtained than embodiment 1.

It should be noted that the IC chip 103 (see fig. 14) may be mounted instead of a magnetic stripe recording the magnetic pattern. In this case, instead of the magnetic reader 40, the IC chip reader may be connected to the main body device 20 and the information recorded in the IC chip 103 may be read by the IC chip reader.

### <Embodiment 4>

In the present embodiment, a case of identifying the functional type of the front panel 10 using an image obtained by imaging the external appearance of the front panel 10 will be described.

In the present embodiment, it is envisaged that the external appearance of the front panel 10 is imaged by a camera serving as a sensor unit 202 of the main body device 20 (see fig. 7) or a camera of a smartphone or tablet terminal capable of communication with the main body device 20.

It should be noted that the external appearance of the front panel 10 is required to have unique features that make it possible to specify the functional type. A table and other information associated with the functional type and unique features extracted from the captured image also need to be provided in the main body device 20, etc.

Other hardware and functional configurations are essentially similar to embodiment 1.

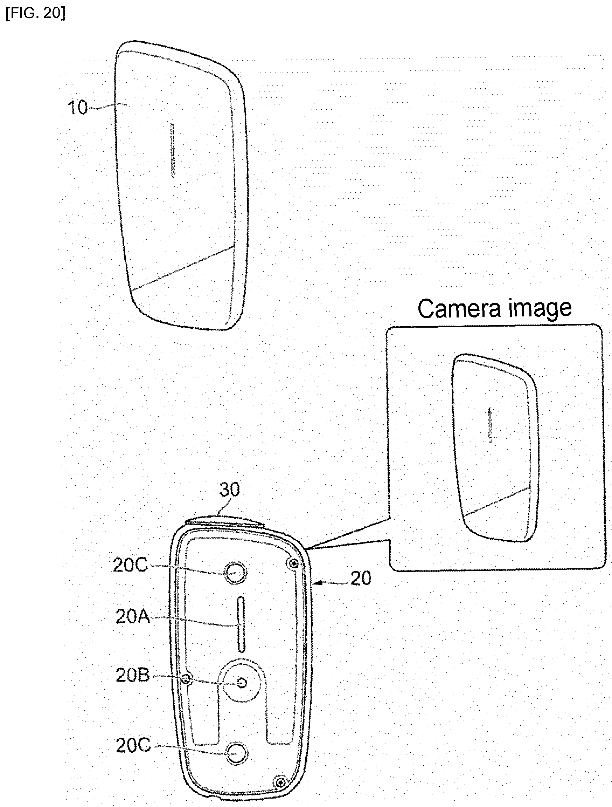

Fig. 20 is a diagram illustrating a method for specifying a functional type of a front panel 10 in embodiment 4. Corresponding reference signs are given in fig. 20 for parts which correspond to those of fig. 1 and 4.

On the face of the front panel 10 shown in fig. 20, a diagonal line is drawn as a pattern representing a functional type. The information used for identification may be represented not only by a pattern, but also the color of the lines constituting the pattern, the thickness of the lines constituting the pattern, color differentiation (e.g., in the example of fig. 20, the combination of the color of the face above the diagonal line and the color of the face below the diagonal line). The pattern may also be formed on the face of the front panel 10 as an uneven pattern or may be represented by the number or size of cut-outs or holes, or a pattern combining these.

The purpose of the external appearance representing the functional type is purely for cooperation with the main body device 20, and thus may not necessarily match the preferences of the user. To address this, an external appearance representing the functional type of the front panel 10 may be provided on the rear face side of the front panel 10. In this case, the user can choose a front panel 10 with a surface texture or design that suits their preferences.

Furthermore, in the case of fig. 20, the external appearance of the front panel 10 to be attached is imaged with a camera provided in the main body device 20 with the front panel 10 removed, but the external appearance of another front panel 10 to be newly attached may be imaged with the front panel 10 attached to the main body device 20.

Furthermore, a smartphone or tablet terminal may be used instead of the main body device 20 in fig. 20 to image the external appearance of the front panel 10, and the captured image may be provided to the main body device 20, from the smartphone or the like, by Bluetooth communication. In this case, the control unit 206 of the main body device 20 processes the received image to specify the functional type of the front panel 10.

It should be noted that the processing for specifying the functional type from the captured image may be implemented on a server operated by the supplier of the front panel 10, etc., or may be implemented on a smartphone, tablet terminal, etc. used by the user. In this case, only the information of the specified result is provided from the server, etc. to the main body device 20. Note that the upload of the image to the server may be implemented directly by the main body device 20 which has captured the image, may be implemented by a smartphone or the like which has received the image from the main body device 20, or may be implemented directly by the smartphone or the like which has captured the image.

### <Summary>

In the present embodiment, the external appearance of the front panel 10 can be imaged using a camera mounted in the main body device 20 or a camera mounted in a smartphone, etc., and the functional type of the front panel 10 can be specified simply by processing the captured image. That is, it is possible to specify the functional type using the image. This requires the external appearance of the front panel 10 to have unique features capable of specifying the functional type, but does not require the structure 102 as in embodiment 1 or installing a communication function in the front panel 10 as in embodiment 2.

### <Embodiment 5>

The present embodiment also uses image information. However, in the present embodiment, a case of identifying the functional type of the front panel 10 using an image obtained by imaging characters printed or engraved on the front panel 10 will be described.

In the present embodiment, the main body device 20 etc. needs to be provided with a function for recognizing a character string from a captured image and a table or other information linking the recognized string with the functional type.

Other hardware and functional configurations are essentially similar to embodiment 1.

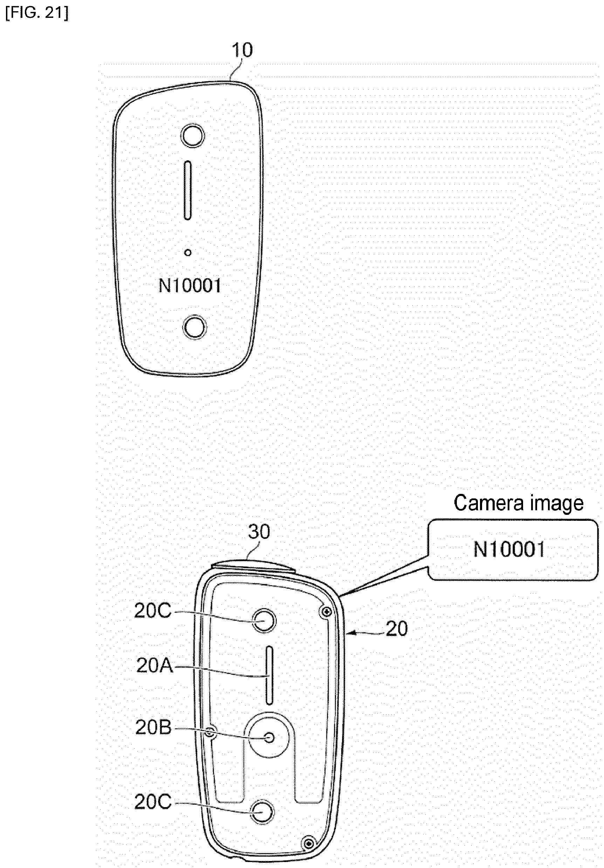

Fig. 21 is a diagram illustrating a method for specifying a functional type of a front panel 10 in embodiment 5. Corresponding reference signs are given in fig. 21 for parts which correspond to those of fig. 1 and 4.

In the case of fig. 21, "N10001" is formed as a printed or uneven pattern on the rear face of the front panel 10.

In the case of fig. 21 also, a character string of the attached front panel 10 is imaged with a camera provided in the main body device 20 with the front panel 10 removed, but the character string of another front panel 10 to be newly attached may be imaged with the front panel 10 attached to the main body device 20.

Furthermore, a smartphone or tablet terminal may be used instead of the main body device 20 in fig. 21 to image the character string printed or the like on the front panel 10, and the captured image may be provided to the main body device 20, such as from the smartphone, by Bluetooth communication.

It should be noted that the processing for specifying the functional type from the captured image may be implemented on a server operated by the supplier of the front panel 10, etc., or may be implemented on a smartphone, tablet terminal, etc. used by the user.

### <Summary>

In the present embodiment, the character string printed or the like on the front panel 10 can be imaged using a camera mounted in the main body device 20 or a camera mounted in a smartphone, etc., and the functional type of the front panel 10 can be specified simply by performing OCR (= Optical Character Recognition) on the imaged character string. That is, it is possible to specify the functional type using the image. Thus, in the present embodiment also, there is no need for the structure 102 as in embodiment 1 or for a communication function to be installed in the front panel 10 as in embodiment 2.

### <Embodiment 6>

The present embodiment also uses image information. However, in the present embodiment, a case of identifying the functional type using an image obtained by imaging a QR code or barcode (hereinafter referred to as "graphic code") printed on the front panel 10 will be described.

In the present embodiment, the main body device 20 etc. needs to be provided with a function for decoding the imaged graphic code to read the functional type.

Other hardware and functional configurations are essentially similar to embodiment 1.

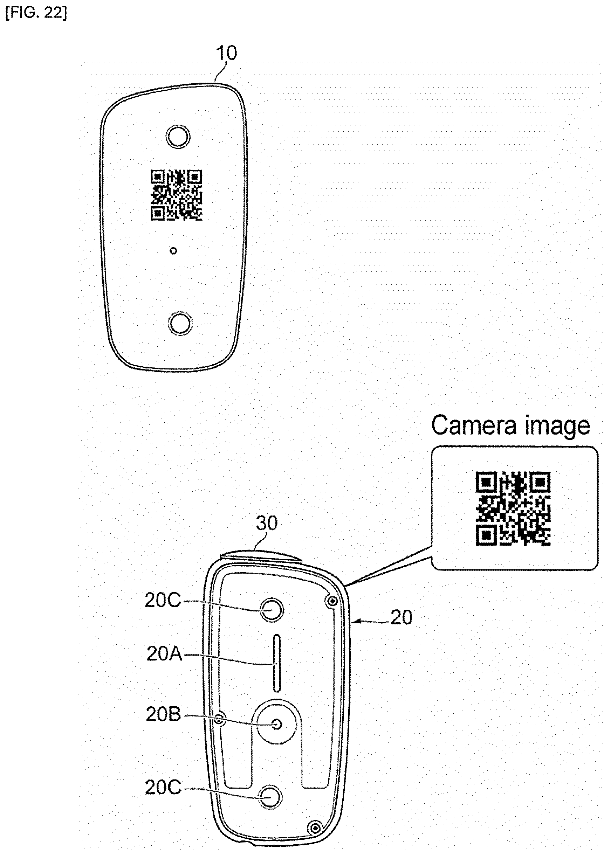

Fig. 22 is a diagram illustrating a method for specifying a functional type of a front panel 10 in embodiment 6. Corresponding reference signs are given in fig. 22 for parts which correspond to those of fig. 1 and 4.

In the case of fig. 22, a QR code is printed on the rear face of the front panel 10.

In the case of fig. 22 also, a QR code of the attached front panel 10 is imaged with a camera provided in the main body device 20 with the front panel 10 removed, but the QR code of another front panel 10 to be newly attached may be imaged with the front panel 10 attached to the main body device 20.

Furthermore, a smartphone or tablet terminal may be used instead of the main body device 20 in fig. 22 to image the QR code printed on the front panel 10, and the image of the captured QR code may be provided to the main body device 20, from the smartphone or the like, by Bluetooth communication, to specify the functional type by processing the image captured by the main body device 20.

It should be noted that the processing for specifying the functional type from the captured QR code may be implemented on a server operated by the supplier of the front panel 10, etc., or may be implemented on a smartphone, tablet terminal, etc. used by the user.

### <Summary>

In the present embodiment, the QR code etc. printed on the front panel 10 can be imaged using a camera mounted in the main body device 20 or a camera mounted in a smartphone, etc., and the functional type of the front panel 10 can be specified simply by processing the captured image. That is, it is possible to specify the functional type using the image. Thus, in the present embodiment also, there is no need for the structure 102 as in embodiment 1 or for a communication function to be installed in the front panel 10 as in embodiment 2.

### <Embodiment 7>

In the present embodiment, focusing on the heating profile readable from the front panel 10, a case will be described in which the functional features of the front panel 10 that is to be attached or attached are identified and reflected in the processing operation of the main body device 20. That is, rather than identifying the functional features from the combination of the mounted electronic components 104, the functional features are identified from the heating profile.

Note that the basic hardware configuration and functional configuration are therefore the same as in embodiment 1.

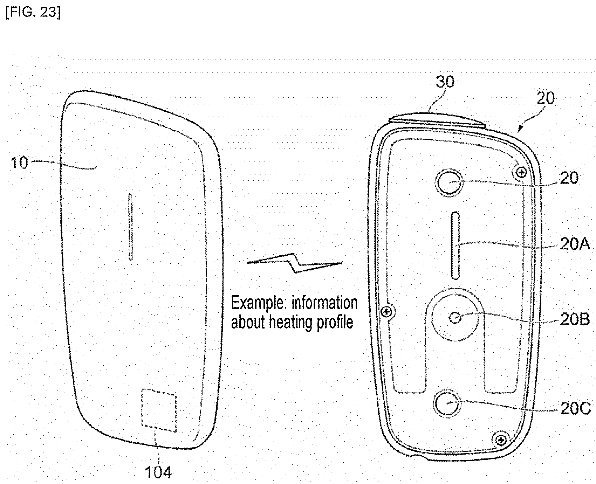

Fig. 23 is a diagram illustrating a method for specifying a functional type of a front panel 10 in embodiment 7. Corresponding reference signs are given in fig. 23 for parts which correspond to those of fig. 1 and 4.

In the case of fig. 23, the front panel 10 is fitted with at least a ROM as an electronic component 104, and a heating profile is recorded in the ROM. In fig. 23, an example is shown in which the information of the heating profile recorded in the front panel 10 is read out by the main body device 20.

The heating profile here includes, for example, the standard profile, the increased amount profile, the reduced amount profile, a temperature-adaptive profile, a humidity-adaptive profile, a profile with pre-heating, and a physical condition-monitoring profile.

The temperature-adaptive profile herein refers to a heating profile comprising a function or the like of switching or adjusting the heating profile in accordance with the temperature during use. In the aerosol generating device 1 (main body device 20) using the front panel 10 that stores this heating profile, the following cooperation operations are implemented, for example.

• The mains power source is forcibly controlled to be OFF when the temperature before the start of inhalation is outside of the use environment temperature (-10°C to +45°C), for example.
• The heating of the aerosol source is not started or heating in progress is stopped when the temperature before the start of inhalation is outside of the use environment temperature (-10°C to +45°C), for example.
• A cooling fan is activated or a Peltier-type cooling unit is actuated in order to lower the temperature in the device when the temperature before the start of inhalation is outside of the use environment temperature (-10°C to +45°C), for example.
• When the temperature before the start of inhalation falls below 5°C, for example, the aerosol source is preliminarily heated (i.e., pre-heated) to a temperature lower than the temperature of the main heating (heating to the temperature at which aerosol is generated from the aerosol source) before the start of the main heating, to increase the aerosol generated during the main heating.

The temperature-adaptive profile refers to a heating profile comprising a function or the like of switching or adjusting the heating profile in accordance with the humidity during use. In the aerosol generating device 1 (main body device 20) using the front panel 10 that stores this heating profile, the aerosol source is pre-heated before the start of main heating when the humidity at the start of inhalation is 80% or greater, for example.

The physical condition-monitoring profile refers to a heating profile for monitoring the physical condition of the user before the start of use or during use (including during inhalation), and controlling the heating operation of the aerosol source. In the aerosol generating device 1 (main body device 20) using the front panel 10 that stores this heating profile, the control unit 206 implements processing such as disabling the heating operation of the aerosol source or stopping the heating operation if an abnormal value is detected in biometric information of the user by comparison with a reference value, for example.

It should be noted that the information representing the heating profile includes, for example, the name and type of the profile, the presence or absence of specific parameter values, the magnitude of numerical values, etc.

It is also possible to infer other electronic components 104 mounted on the front panel 10 when the heating profile of the front panel 10 is recorded in the ROM. It is understood that, when the temperature-adaptive profile is recorded in the ROM, for example, a temperature sensor is mounted on the front panel 10 and the measured temperature can be obtained by communication with the main body device 20. Similarly, it is understood that, when the humidity-adaptive profile is recorded in the ROM, for example, a humidity sensor is mounted on the front panel 10 and the measured humidity can be obtained by communication with the main body device 20.

### <Summary>

The present embodiment is limited to situations where a heating profile is recorded on the front panel 10, but there is no need to provide the front panel 10 with the structure 102 or external appearance features that represent functional types as in other embodiments.

Additionally, in the present embodiment also, a cooperation operation corresponding to the heating profile of the front panel 10 is automatically realized by the user simply attaching the used front panel 10 to the main body device 20.

### <Other Embodiments>

(1) Embodiments of the present disclosure were described above, but the technical scope of the present disclosure is not limited to the scope disclosed in the embodiments above. It will be obvious from the disclosure of the claims that the technical scope of the present disclosure also includes various modifications or improvements made to the embodiments above.
(2) The embodiments above described a case in which the junction between the front panel 10 and the main body device 20 forms a continuous and stepless joint with an integral external appearance, but the junction may also include a step or cutout, etc., provided that there is an integral external appearance with the main body device 20.
(3) The embodiments above described a case in which the aerosol source is a solid, but the aerosol source may equally be a liquid. When the aerosol source is a liquid, a system is adopted in which the aerosol source is guided to a narrow tube known as a wick by using a capillary phenomenon, and a coil wound around the wick is heated to thereby vaporize the aerosol source.
(4) The embodiments above described an aerosol generating device which generates an aerosol by heating a solid aerosol source, but the aerosol generating device may equally generate an aerosol by separately heating each of a solid aerosol source and a liquid aerosol source. An aerosol generating device of this type is also referred to as a hybrid aerosol generating device.
(5) The embodiments above described the aerosol generating device 1 (main body device 20) to which the front panel 10 is attached as an example of an electronic device, but the electronic device may equally be an electronic device which is usable in a state in which a cover member (including a main body cover or a protective cover) or a panel member is attached, the cover member or panel member being detachable from the device main body, and examples of such electronic devices include a remote control, a gaming device, a music player, a video camera, a digital camera, an electronic dictionary, and an electronic calculator.
(6) The embodiments above described an example in which aerosol generation is permitted only when the front panel 10 is attached to the main body device 20, but aerosol generation may also be possible while the front panel 10 is not attached to the main body device 20.

In this case, attachment of the front panel 10 to the main body device 20 is used to broaden the functions that may be implemented by the main body device 20. For example, the main body device 20 with the front panel 10 removed operates using only the built-in secondary battery 201A (see fig. 16), and the main body device 20 to which the front panel 10 fitted with the secondary battery is attached enables a function of using power from the battery on the front panel 10 (primary battery, secondary battery 104).

(7) The embodiments above described a state in which aerosol generation is possible as an example of the aerosol generating device 1 (main body device 20) being in an operable state, but this is not limiting. For example, the aerosol generating device 1 (main body device 20) is in an operable state even if an aerosol cannot be generated due to a lack of power, provided that another function is operating. The other function as referred to here includes, for example, a function for checking and presenting remaining charge in the secondary battery 201A, etc., a function for acquiring and presenting an inhalation history, and a function for communicating with an external terminal.

(8) The embodiments above described an example in which the button 20B provided on the main body device 20 is operated by pressing the front panel 10 fitted to the main body device 20 to cause deformation, but input instructions to the main body device 20 may also employ a method other than deformation of the front panel 10.

For example, a touch panel may be provided on the front panel 10 as a notification unit, and information indicating a user operation on the touch panel may be notified to the control unit 206 (see fig. 7) in the main body device 20 via a communication unit which is not depicted.

Furthermore, a switch or button may be arranged on the front panel 10, and the presence or absence, etc. of an operation thereon may be notified to the control unit 206 (see fig. 7) in the main body device 20 via a communication unit which is not depicted. The touch panel and switch, etc. as referred to here are examples of an operating unit.

Moreover, a heat shielding structure is used on surface members and inside a main body device 20 of this type.

### <Summary>

It should be noted that the present disclosure includes the following features.
(1) An electronic apparatus having a control unit and a battery, wherein the control unit identifies a functional type of a cover member to be attached or attached to an apparatus main body.
(2) The electronic apparatus according to (1), wherein the control unit specifies an electronic component provided to the cover member on the basis of an identification result of the functional type.
(3) The electronic apparatus according to (1) or (2), wherein the control unit controls cooperation with an electronic component provided to the cover member on the basis of an identification result of the functional type.
(4) The electronic apparatus according to any one of (1)-(3), wherein the control unit identifies the functional type of the cover member through detection of a structural feature provided to the cover member.
(5) The electronic apparatus according to any one of (1)-(3), wherein the control unit identifies the functional type of the cover member through reading a magnetic pattern.
(6) The electronic apparatus according to any one of (1)-(3), wherein the control unit identifies the functional type of the cover member by information read through communication with the cover member.
(7) The electronic apparatus according to any one of (1)-(3), wherein the control unit identifies the functional type of the cover member using an image of the cover member imaged by a camera.
(8) The electronic apparatus according to (7), wherein the control unit reads character information on the cover member as the image.
(9) The electronic apparatus according to (7), wherein the control unit reads graphic code affixed on the cover member as the image.
(10) The electronic apparatus according to any one of (1)-(3), further including a heating unit for heating an aerosol source, wherein the control unit identifies the functional type on the basis of information representing a control sequence readable from the cover member.
(11) The electronic apparatus according to any one of (1)-(10), wherein the attachment of the cover member on the apparatus main body causes a portion of a face of the apparatus main body to be covered with the cover member.
(12) The electronic apparatus according to any one of (1)-(11), further including a heating unit for heating an aerosol source, wherein the control unit detects the attachment of the cover member on the apparatus main body as one of conditions to enable heating of the aerosol source by the heating unit.
(13) The electronic apparatus according to any one of (1)-(12), wherein the cover member attached to the apparatus main body allows operation of a switch provided on the apparatus main body by pressing by a user.
(14) The electronic apparatus according to any one of (1)-(13), wherein a portion of the apparatus main body that is not covered by the cover member forms an integral external appearance with the cover member.
(15) A program for causing a computer provided in an electronic apparatus having a battery to realize a function for identifying a functional type of a cover member to be attached or attached to an apparatus main body.

### [Reference Signs List]

1 ... aerosol generating device, 10 ... front panel, 10A ... main body panel, 10B ... window, 10C, 20C ... magnet, 20 ... main body device, 20A ... LED, 20B ... button, 20D ... sensor, 21 ... USB connector, 22 ... hole, 30 ... shutter, 101 ... primary battery, 102 ... structure, 103 ... IC chip, 104 ... electronic component, 105 ... remaining charge meter, 106 ... step-up/step-down DC/DC circuit ... 201 ... power source unit, 201A ... secondary battery, 201B ... power supply unit, 202 ... sensor unit, 203 ... notification unit, 204 ... memory unit, 205 ... communication unit, 206 ... control unit, 207 ... heating unit, 208 ... heat insulating portion, 209 ... holding portion, 210 ... stick-type substrate

## Claims

1. An electronic apparatus having a control unit and a battery,
wherein the control unit identifies a functional type of a cover member to be attached or attached to an apparatus main body.

2. The electronic apparatus as claimed in claim 1, wherein the control unit
specifies an electronic component provided to the cover member on the basis of an identification result of the functional type.

3. The electronic apparatus as claimed in claim 1 or 2, wherein the control unit
controls cooperation with an electronic component provided to the cover member on the basis of an identification result of the functional type.

4. The electronic apparatus as claimed in any one of claims 1-3, wherein the control unit
identifies the functional type of the cover member through detection of a structural feature provided to the cover member.

5. The electronic apparatus as claimed in any one of claims 1-3, wherein the control unit
identifies the functional type of the cover member through reading a magnetic pattern.

6. The electronic apparatus as claimed in any one of claims 1-3, wherein the control unit
identifies the functional type of the cover member by information read through communication with the cover member.

7. The electronic apparatus as claimed in any one of claims 1-3, wherein the control unit
identifies the functional type of the cover member using an image of the cover member imaged by a camera.

8. The electronic apparatus as claimed in claim 7, wherein the control unit
reads character information on the cover member as the image.

9. The electronic apparatus as claimed in claim 7, wherein the control unit
reads graphic code affixed on the cover member as the image.

10. The electronic apparatus as claimed in any one of claims 1-3, further including a heating unit for heating an aerosol source, wherein the control unit
identifies the functional type on the basis of information representing a control sequence readable from the cover member.

11. The electronic apparatus as claimed in any one of claims 1-10, wherein the attachment of the cover member on the apparatus main body causes a portion of a face of the apparatus main body to be covered with the cover member.

12. The electronic apparatus as claimed in any one of claims 1-11, further including a heating unit for heating an aerosol source,
wherein the control unit
detects the attachment of the cover member on the apparatus main body as one of conditions to enable heating of the aerosol source by the heating unit.

13. The electronic apparatus as claimed in any one of claims 1-12, wherein the cover member attached to the apparatus main body allows operation of a switch provided on the apparatus main body by pressing by a user.

14. The electronic apparatus as claimed in any one of claims 1-13, wherein a portion of the apparatus main body that is not covered by the cover member forms an integral external appearance with the cover member.

15. A program for causing a computer provided in an electronic apparatus having a battery to realize:
a function for identifying a functional type of a cover member to be attached or attached to an apparatus main body.
